# EUROPEAN PATENT APPLICATION

(11) **EP 2 444 771 A2**
(43) Date of publication of application: **25.04.2012**
(21) Application number: 11185918.7
(22) Date of filing: 20.10.2011
(51) Int. Cl.: F41A 21/04, C23C 14/06

(54) **Barrel**

(30) Priority: 21.10.2010 IT MI20101928
(71) Applicant: Protec Surface Technologies S.r.L., 25081 Bedizzole (BS) (IT)
(72) Inventor: Pitacco, Fabrizio, I - 25081 Bedizzole (Brescia) (IT); Tosti, Michele, I - 25081 Bedizzole (Brescia) (IT)
(74) Representative: Lunati & Mazzoni S.r.L.

(57) **Abstract**

It is provided an improved barrel (1) comprising a first hollow portion (2) having a preferred rectilinear extension direction (2a) and comprising an inner surface (2c) defining a bore (2b) adapted to be travelled over by a projectile, said first hollow portion (2) comprising an inner layer (4a) constituting said inner surface (2c) obtained through deposition of diamondoids by a high-vacuum process.

## Description

The present invention relates to an improved barrel of the type pointed out in the preamble of the first claim.

It is known that a barrel is generally made up of a metal tube of high strength and with an inner cavity adapted to enable passage of the projectiles and to contain the pressures usually resulting from burning of the gunpowder.

The improved barrel mainly performs the function of determining the exit direction of the projectile from the firearm and therefore determines the accuracy of the firearm itself. In detail, this function is performed by a first hollow portion of the barrel defining a cavity travelled over by the projectile at the shot and referred to as bore, as better described hereinafter.

In addition to the first hollow portion, the barrel usually has a second hollow portion adapted to receive the cartridge before the shot, to convert the pressure energy generated on occurrence of the above described burning into movement energy of the projectile and to promote insertion of the projectile into the barrel and enable easy removal of the cartridge case after the shot.

The second hollow portion, such as in case of pistols and rifles for example, is usually of one piece construction with said first portion. If a revolver is concerned, the second portion constitutes a distinct piece relative to the first portion which is movable relative to the first portion itself. Practically, in revolvers, the function of the second portion is substantially performed by the cylinder.

The most important part of the barrel of a firearm is generally the bore that, depending on the type of use and the ammunitions used, can be smooth or rifled. In case of a smooth bore the inner surface is of substantially cylindrical shape. The most common smooth bores are those of the smooth-bore rifles which are adapted to fire different types of projectiles, such as shots and large shots. Another type of smooth bore firearm is represented by guns with auto-stabilising projectiles such as rockets or rocket-assisted projectiles, provided with fins for independent stabilisation. Another class of smooth-bore weapons are mortars charged from the mouth and many portable guns without recoil.

On the contrary, in case of a rifled bore, the inner surface has one or more grooves of helical course adapted to set the projectile in rotation around its own axis in order the stabilise the trajectory thereof and increase the firearm range. These firearms have a much greater useful range than the smooth-bore firearms, because the axial rotation imparted by the helical grooves to the projectile produces a gyroscopic effect reducing the problems resulting from possible asymmetries or unevennesses and makes the projectile less sensitive to external influences. The negative side of the rifled bore is the necessity of greater gas pressures in the bursting chamber because, in addition to throwing the projectile, they must also introduce it by force into the grooves to impart the rotary motion thereto. Except for rare exceptions, the rifled-bore firearms comprise almost the whole of pistols and portable automatic firearms and some rifles.

Polygonal bores are finally present, i.e. bores having a faceted hexagonal or octagonal inner profile, still characterised by a helical course. This type of barrel is mainly used for manufacturing small weapons.

Presently, manufacture of barrels is made through working of a steel bar by chip removal.

In detail, smooth-bore barrels are produced by boring a steel bar and subsequently submitting it to a hammer rolling process or other similar working operations adapted to obtain a smooth and strong bore surface. Then these barrels are submitted to a heat treatment, adapted to minimise the internal stresses created by the hammer rolling process and finally they are lapped to obtain a good surface finish.

In case of rifled- or polygonal-bore barrels the above described operations are carried out by a broaching process adapted to obtain the particular profile of the barrel bore. Once the barrel bore has been obtained, the outer surface of the barrel is submitted to burnishing so as to create a layer adapted to provide a protection against oxidation and improve the aesthetic aspect of same. This process also has the fundamental purpose of creating an antireflection surface so that the user always has the possibility of sighting without the light troubling him/her.

One of the most important aspects surely is selection of the materials used for manufacturing barrels for firearms. In particular, these materials must be adapted to withstand the high stresses that are generated at the shot, as well as those due to the projectile motion inside the barrel bore.

A further fundamental aspect in selection of the materials is given by the mechanical elasticity that must be adapted to enable expansion/elongation in case of overstresses, avoiding breaking of the material.

Another fundamental aspect in selecting the materials is represented by the friction coefficient which must be as low as possible so as not to reduce the firearm's range.

Further fundamental aspects to be taken into account finally are resistance to wear, oxidation and high temperatures of the material.

The materials presently used are therefore compound steels such as nickel-chromium, chromium-vanadium or chromium- molybdenum steels. Another type of steels used are the so-called high-speed steels which are characterised by high tungsten content and are adapted not to lose hardening even if heated to temperatures higher than 500°C.

The known art mentioned above has some important drawbacks.

A first problem belonging to present barrels is represented by the poor quality of same. In particular, the presently used barrels have a substantially high friction coefficient, limiting the firearm's range, and a reduced strength.

Another problem is represented by the limited duration of known barrels.

In fact, bursting and the huge forces coming into play during the shot give origin to strong stresses that quickly deteriorate the barrel bore. In particular, these forces lead to quick surface deterioration that increases friction between the projectile and the bore thereby decreasing the firearm's maximum range and the accuracy thereof.

This deterioration can further lead to formation of scratches and furrows impairing the firearm's accuracy. In rifled-bore barrels the surface deterioration can bring to deformation of the groove and therefore to decay of the firearm's quality.

For the above reason a firearm requires frequent and complicated maintenance works designed to limit deterioration thereof.

A further aspect causing quick surface wear is due to the working operations causing a negative stress condition and therefore leading to creation of critical areas.

A further aspect limiting the firearm's duration is represented by the fact that, due to the high temperature changes, the bore is subjected to creep, i.e. to formation of surface and under-surface cracks that can lead to breaking of the barrel.

The above aspects, limiting the barrel duration, can lead to a wrong operation of the firearm itself and therefore can give rise to serious problems for the user. In particular, said creep phenomenon due to formation of under-surface cracks, is hardly findable by the user and therefore can cause an unexpected and dangerous malfunction of the firearm.

Finally, there are some barrels having the inner part coated by means of electrochemical or chemical deposition processes. These coatings, not only give rise to a high increase in the production costs, by also only partly solve the above-listed problems. In these firearms, in fact, only a reduced increase in the capacity of carrying out an abrasion-proof and corrosion-proof protection is found.

These problems have been further emphasised by use of projectiles made of a material increasingly stronger that lead to a quicker deterioration of the inner barrel surface.

Under this situation, the technical task underlying the present invention is to conceive an improved barrel capable of substantially obviating the mentioned drawbacks.

Within the scope of this technical task, it is an important aim of the invention to provide a barrel of high quality. In particular, it is an essential aim of the invention to make available a barrel capable of ensuring a higher range and greater accuracy as compared with those presently used.

Another important aim of the invention is to provide an improved barrel characterised by a great duration and reliability.

It is an important objective of the invention to manufacture a barrel capable of ensuring long duration and reliability also with particularly hard projectiles.

A further aim of the invention is to create a barrel that does not require frequent and complicated maintenance works.

Another important aim of the invention is to produce barrels of high quality, but at low production costs.

The technical task mentioned and the aims specified are achieved by an improved barrel as claimed in the appended Claim 1.

Preferred embodiments are highlighted in the sub-claims.

The features and advantages of the invention are hereinafter clarified by the detailed description of preferred embodiments of the invention, with reference to the accompanying drawings, in which:

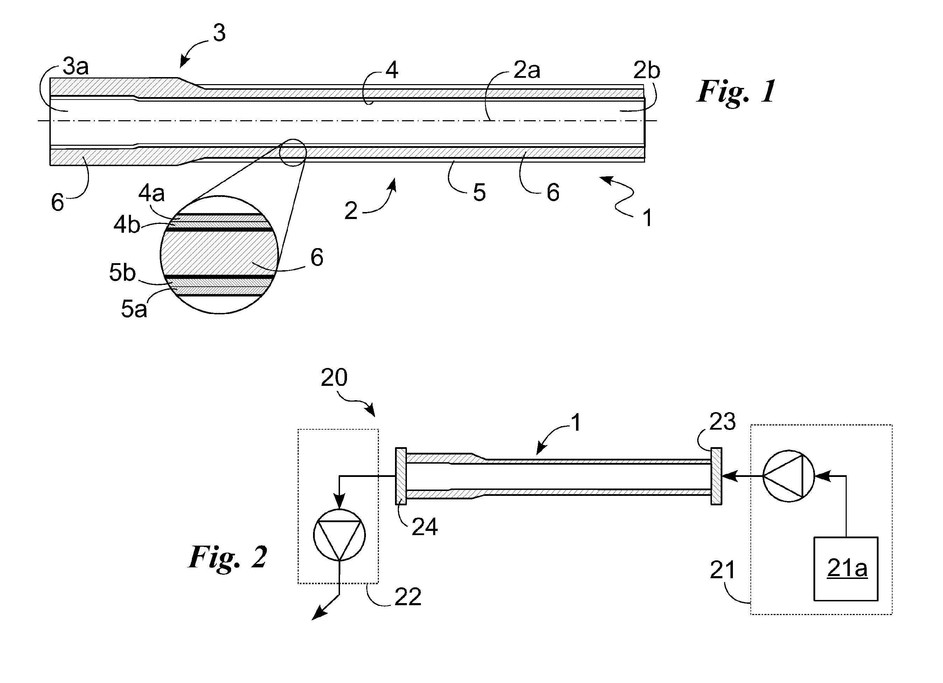

**Fig. 1** shows the improved barrel according to the invention; and
**Fig. 2** shows an apparatus adapted to manufacture a barrel according to the invention.

With reference to the drawings, the improved barrel in accordance with the invention is generally identified by reference numeral **1**.

In particular, barrel 1 can be used for accomplishment of an indirect-action weapon, i.e. a weapon in which the bursting energy is used for projecting an object, named projectile, towards a selected target at high speed. In detail, this weapon is a firearm, i.e. a thermo-ballistic machine that, for throwing the projectile, utilises the energy resulting from a chemical reaction and, more specifically, utilises the kinetic energy of a gas being expanded generated by a propelling charge or a burst.

The firearm can be a small or long arm. The long arm is a light arm dedicated to shots over long distances. It has a long barrel 1, i.e. the barrel's length exceeds about twenty times the nominal diameter of barrel 1. This firearm is brought to the firing position using both hands always utilising the shoulder's support for bearing it during the sighting and shot. Typical of this category are rifles, carbines, muskets, machine-guns and some types of submachine gun.

The small firearm has a relatively short barrel and generally it is grasped with one hand alone. Falling within this category are pistols, revolvers and also some types of light submachine gun, although the last-mentioned type in order to enable control during the volley fire, is grasped with both hands.

The firearm, in addition to the above mentioned types, can be a heavy weapon. This being stated, it is pointed out that barrel 1 is particularly adapted for long firearms such as rifles and carbines. Hereinafter, the firearm is preferably intended to be a rifle, although other applications are not to be excluded.

The projectile, adapted to be used with one of said firearms, can consist of a single metal element usually ogive-shaped or of one or more shots/large shots, i.e. one or more balls. These projectiles are usually partly suitably surrounded by adapted envelopes, the so-called cases, containing, in addition to said projectile, also the propelling charge, gunpowder for example, and the primer adapted to initiate the chemical reaction upon command. The assembly consisting of projectile, case, propelling charge and primer is commonly referred to as cartridge.

In detail, the improved barrel 1, being the object of the invention, in known manner comprises a first hollow portion **2** having a substantially rectilinear major extension direction **2a** and provided with a through hole defining the bore **2b** of barrel 1 encircled by an inner surface **2c**. The bore 2b is adapted to be travelled over by the projectile at the shot and, according to the type of weapon for which the barrel is made, can be of the smooth type, rifled type or polygonal type. In the two last-mentioned cases the bore 2b can have a substantially smooth first portion of frustoconical shape promoting entry of the projectile into the grooves of the bore itself.

The bore 2b has a substantially cylindrical shape. In particular, in case of smooth bore it can show a section for entry of the projectile that is bigger than the exit section in order to improve accuracy of the weapon itself. In this case, the barrel's smooth-bore 2b has a frustoconical shape or, alternatively, two cylindrical sectors of different diameter mutually connected by a conical intermediate sector.

Barrel 1, in addition to said first hollow portion 2, may comprise a second hollow portion **3** defining a housing chamber **3a** accommodating at least part of a cartridge before the shot and having a preferred extension axis substantially coincident with the direction 2a of the first portion 2. This second hollow portion 3 can be made integral with the first portion and preferably of one piece construction with the first hollow portion 2. Alternatively, the hollow portions 2 and 3 consist of two distinct pieces that can be mutually moved.

The housing chamber 3a is such shaped as to perform the following functions: receiving the cartridge before the shot; enabling insertion of the projectile into the bore 2b at the shot while the case remains inside the chamber; ensuring quick ejection of the case after the shot.

According to the invention, the first hollow portion 2 comprises an inner layer **4a** constituting said inner surface 2c obtained by deposition of diamondoids by a high-vacuum process, in particular a PECVD process.

Specifically, the first hollow portion 2 comprises a base body **6** made of steel, special steels or the like, and an inner coating **4** comprising the inner layer 4a and at least one intermediate layer **4b** included between the base body 6 and the inner coating 4 and adapted to ensure adhesion of the inner layer 4a to the base body 6.

The intermediate layers 4b can have physico-mechanical features different from each other and therefore in coating 4 layers of different thickness or material can be identified.

The inner coating 4, made by high-vacuum deposition, is characterised by an overall thickness included between 0.1µm and 30 µm.

The expression "high-vacuum deposition" identifies those coating processes made in under-vacuum chambers, i.e. environments the inner pressure of which is very low and, more specifically, in high-vacuum chambers, i.e. with inner pressures substantially included between 10⁻¹ Pa and 10⁻⁵ Pa. Among the most important high-vacuum processes there are the known PVD and PECVD techniques. PVD, i.e. "Physical Vapour Deposition" is an atomic deposition process for example, in which the material to be deposited is evaporated from the solid phase and conveyed in the vapour phase until the pieces to be covered where it lays down to form a thin film.

Unlike the preceding one, the PECVD process, i.e. the "Plasma-enhanced chemical vapour deposition" uses a precursor already in the vapour phase, containing the chemical species to be deposited that are made available for film formation through the plasma action. Creation of this first inner coating 4, and in particular the inner layer 4a is preferably carried out by the PECVD process, or alternatively the PVD process.

The inner layer 4a is further carried out through deposition of nanoparticles made up of diamondoids.

Diamondoids are nanoparticles mostly having the crystalline lattice of the diamond. These diamondoids preferably consist of one or more molecules of a C₁₀H₁₆ hydrocarbon of a structure similar to that of the diamond and commonly named adamantane.

Diamondoids are present in petroleum with a concentration usually included between 1-10 ppm, from which they can be extracted by the known HPLC (High Performance Liquid Chromatography) technique. In detail the HPLC is a chromatographic technique enabling two or more compounds present in a solvent to be separated by utilising the affinity equilibrium. Once extracted, these particles are crystallised again with each other following standard techniques of organic chemistry.

For instance, these particular nanoparticles are described in paragraph [0015] to paragraph [0021] in the US patent application 20090029067.

The intermediate layers 4b too can be identical with or similar to the inner layer 4a.

The improved barrel 1 in addition to having the first inner coating 4 also originally has a particular outer coating **5** made on at least part of the outer surface of the first hollow portion 2. This outer coating 5 is made up of at least one layer obtained by a high-vacuum deposition process, such as PVD and PECVD.

Preferably, the outer coating 5 has several layers with physico-mechanical features different from each other and therefore in the outer layer 5 layers with different thickness and/or having nanoparticles of different material can be identified. The outer coating 5 therefore comprises an outer layer **5a** defining the outer surface of barrel 1 and preferably at least one lower layer **5b** interposed between the outer layer 5a and the base body 6.

The lower layer 5b, in addition to improving the physico-chemical features of barrel 1, ensures adhesion of the outer layer 5a to barrel 1 or the underlying layers of the outer coating 5. The lower layer 5b, like the inner layer 4b, is therefore made up of a material adapted to perform the aforesaid functions such as silicon carbide, pure metal, nitrided metal, carbonitrided metal or a combination thereof.

The outer layer 5a is made by deposition of diamondoids, DLC or other similar material adapted to ensure an appropriate strength to the outer surface of barrel 1. Preferably, this outer layer 5a has nanoparticles of diamondoids or DLC.

In addition, the outer coating 5 and in particular the outer layer 5a is preferably adapted to ensure a high protection to barrel 1 and at the same time to avoid light phenomena, such as reflections that can cause trouble to the user while he/she is sighting the objective. Alternatively, this antireflection feature can alternatively be obtained by painting or other similar process adapted to obtain a layer having this feature.

Finally, the inner coating 4, in particular the inner layer 4a, and outer coating 5 preferably also extend at the second hollow portion 3.

The invention comprises a new process for manufacturing an improved barrel.

In this process it is contemplated a forming step adapted to make the base body 6 and an inner deposition step, for deposition of diamondoids by the high-vacuum process on the inner surface 2c, and preferably an outer deposition step. In detail, in the forming step the shape of the base body 6 is made following presently known techniques some examples of which have been previously described.

The inner deposition step forms the inner layer 4a and preferably further comprises deposition of at least one intermediate layer 4b that, together with the inner layer 4a, forms the previously described inner coating 4.

The outer deposition step, preferably carried out after or simultaneously with the inner deposition step, on the contrary forms the outer coating 5, in particular the previously described outer coating 5a.

The inner and outer deposition steps preferably include a plurality of sub-steps for making the intermediate layers 4b and lower layers 5b, respectively. In some cases, an initial sub-step can be provided for pre-treatment, such as a surface finish, in which the surface to be coated is prepared for deposition. In particular, each of the sub-steps belonging to the inner deposition are carried out by high-vacuum deposition, according to PECVD. Preferably, deposition of each layer takes place following the PECVD technique.

Accomplishment of the inner coating 4 is carried out by a suitable apparatus **20** diagrammatically shown in Fig. 5, adapted to use the barrel itself as a vacuum chamber, i.e. adapted to bring the pressure at least of bore 2b to values suitable to carry out a high-vacuum deposition.

This deposition apparatus 20 briefly comprises at least one pair of heads adapted to enclose and tighten at least one barrel 1 and in particular a base body 6; at least one feeding system **21** of known type, capable of providing an appropriate fluid flow containing the nanoparticles to be deposited; an adjusting system **22** comprising pumps for example, adapted to adjust the pressure inside at least part of the inner volume of barrel 1; and control means, not shown in the figure, adapted to control the outgoing and incoming flow from and into the inner volume, such as valves for example. More specifically, the deposition apparatus 20 therefore comprises at least one first head **23** and one second head **24** adapted the sealingly close the inner volume. Therefore each of the two heads 23 and 24 comprises releasable fastening means, adapted to releasably secure barrel 1 in a hermetically tight manner to one of the heads.

In order to carry out the high-vacuum deposition, the first head 23 and second head 24 are respectively connected to the feeding system 21 and the adjusting system 22 and are therefore adapted to bring the inner volume into communication for fluid passage with systems 21 and 22 respectively. In detail, the first head 23 allows fluid introduction, gas or plasma containing the nanoparticles for example, into the inner volume, while the second head 24 enables the inner volume to be brought to the necessary pressure for high-vacuum deposition.

At the beginning of the inner deposition step, heads 23 and 24 are fastened to barrel 1, carrying out said hermetic seal, and the inner volume of barrel 1 is brought to the necessary pressure for high-vacuum deposition by the adjusting systems 22. At this point the feeding system 21 is activated and it introduces the nanoparticles contained in one of containers **21a** into the barrel 1 thus obtaining a first layer of the inner coating 4.

When the first layer has been completed, barrel 1 is prepared for making the second layer. This deposition can be carried out through another pair of heads 23 and 24 or preferably by use of the same pair of heads 23 and 24, so that the whole inner coating 4 is obtained without moving barrel 1. In this case the feeding system is provided with several containers 21, each of which contains a type of nanoparticles.

At the end of the inner deposition step the intermediate layer 4b and finally the inner layer 4a completing the inner coating 4 are laid down.

Another example of a process for obtaining the coating of inner surfaces through high-vacuum deposition is disclosed in the patent application US 2006198965 describing a method of depositing nanoparticles on the inner surface of a tube portion. A further example is present in the patent application US 2006196419 A1 in which a process is described that is adapted to lay down nanoparticles on a selected portion of the inner surface of a tube.

When the inner coating 4 has been completed, heads 23 and 24 are moved apart from barrel 1 that is thus cleared and prepared for the outer deposition step in which one or more barrels are disposed inside a high-vacuum deposition chamber.

In this case, unlike the preceding operations, one or more barrels 1 are laid inside an appropriate chamber in which through high-vacuum deposition, the outer coating 5 is obtained. In detail, the outer deposition step consists of one or more sub-steps each of which forms a coating layer. These sub-steps can be preceded by a pre-treatment sub-step adapted to prepare the outer surface before carrying out the outer coating 5, through elimination of possible surface faults for example.

Finally, the inner and outer deposition steps can be carried out in parallel, i.e. at least part of the inner coating 4 and at least part of the outer coating 5 can be carried out simultaneously. In detail, it is possible to simultaneously obtain both an inner coating layer 4 and an outer coating layer 5.

The invention allows important advantages to be achieved.

In fact, barrel 1 as made has exceptional physico-mechanical features enabling a firearm provided with barrel 1 to have a greater range and duration as compared with the same weapon having one of the presently known barrels. The range increase is obtained due to the particular inner coating 3 providing barrel 1 with reduced friction as compared with those presently known. Another advantage connected with the reduced friction due to the inner coating 3 is represented by the accuracy ensured by a weapon provided with barrel 1. In fact, this coating ensures a high surface quality and therefore optimises the sighting of the projectile by the barrel itself.

Another advantage connected with the inner coating 4 and in particular the nanoparticles used is represented by the self-lubricating capability of the coating itself. This feature allows the maintenance operations of the weapon to be minimised.

Another advantage connected with barrel 1 is the high reliability of same. This is due to both the inner 3 and outer 4 coatings that greatly reduce erosion and surface deterioration relative to the features of known barrels.

This advantage also results in a greater safety level and duration of barrel 1 and therefore of the firearm.

An important objective reached by the invention is the reduction of the production time and costs, which reduction is obtained by the possibility of simultaneously carrying out, on several barrels 1, both a single type of inner coating 3 and coatings having layers of nanoparticles different from one barrel to another.

This advantage is further obtained due to the possibility of simultaneously laying down both inner coating layers 4 and outer coating layers 5.

Another important advantage obtained on coating barrel 1 is given by the possibility of using materials of poorer quality for manufacturing the barrel itself. In fact, the inner coating alone 4 is in contact with the projectile and therefore it is only the inner coating that must absorb stresses and resist erosion due to the projectile motion and the bursting occurring at the shot.

The invention is susceptible of variations falling within the inventive idea. All of the details can be replaced by equivalent elements and the materials, shapes and sizes can be of any nature and magnitude.

## Claims

1. An improved barrel (1) comprising a first hollow portion (2) having a preferred rectilinear extension direction (2a) and comprising an inner surface (2c) defining a bore (2b) adapted to be travelled over by a projectile, **characterised in that** said first hollow portion (2) comprises an inner layer (4a) constituting said inner surface (2c) obtained through deposition of diamondoids by a high-vacuum process.

2. An improved barrel (1) as claimed in claim 1, wherein said inner layer (4a) is obtained by a PECVD process.

3. An improved barrel (1) as claimed in one or more of the preceding claims, wherein said first hollow portion (2) comprises a base body (6) and an inner coating (4) including said inner layer (4a) and at least one intermediate layer (4b) placed between said base body (6a) and inner coating (4) and adapted to ensure adhesion of said inner layer (4a) to said base body (6).

4. An improved barrel (1) as claimed in one or more of the preceding claims, wherein the outer surface of said first hollow portion (2) comprises an outer coating (5) including at least one layer deposited by a high-vacuum process on at least part of the outer surface of said first hollow portion (2).

5. An improved barrel (1) as claimed in the preceding claim, wherein said outer coating (5) comprises an outer layer (5a) obtained by deposition of diamondoids.

6. An improved barrel (1) as claimed in one or more of claims 4-5, wherein the outer coating (5) comprises a lower layer (5b) included between said base body (6) and outer layer (5a) and adapted to ensure adhesion of said outer layer (5a) to said improved barrel (1).

7. A process for manufacturing an improved barrel (1) comprising a first hollow portion (2) having a rectilinear preferred extension direction (2a) and including an inner surface (2c) defining a bore (2b) adapted to be travelled over by a projectile, said process comprising a forming step adapted to manufacture a base body (6) and **characterised in that** it comprises a step of carrying out an inner deposition of diamondoids by a high-vacuum process on said inner surface (2c).

8. A process as claimed in claim 7, wherein said inner-deposition step is carried out by a PECVD process.

9. A process as claimed in one or more of claims 7-8, wherein said inner-deposition step forms at least one intermediate layer (4b) placed between said base body (6) and inner coating (4) and adapted to ensure adhesion of said inner layer (4a) to said base body (6).

10. A process as claimed in one or more of claims 7-9, comprising an outer-deposition step adapted to lay down an outer coating (5), through a high-vacuum process, on at least part of the outer surface of said first hollow portion (2).

11. A manufacturing process as claimed in the preceding claim, wherein said outer-deposition step and inner-deposition step are made simultaneously.
